# EUROPEAN PATENT SPECIFICATION

(11) **EP 1 526 410 B1**
(45) Date of publication and mention of the grant of the patent: **21.11.2012**
(21) Application number: 04023885.9
(22) Date of filing: 07.10.2004
(51) Int. Cl.: G03F 7/36

(54) **Method and apparatus for thermal development**
Verfahren und Vorrichtung zur thermischen Entwicklung
Procédé et appareil pour développement thermique

(30) Priority: 16.10.2003 US 512568 P; 15.01.2004 US 759814
(43) Date of publication of application: 27.04.2005
(73) Proprietor: E.I. DU PONT DE NEMOURS AND COMPANY, Wilmington, DE 19898 (US)
(72) Inventor: Hackler, Mark A., Ocean New Jersey 07712-3343 (US); Kannurpatti, Anandkumar R., E. Windsor New Jersey 08520 (US); Mc Millen, Robert A., Downingtown Pennsylvania 19335 (US); Shamlin, Wilford, Newark Delaware 19711 (US); Lake, Jeffrey Robert, Pittsford New York 14534 (US); Neufeglise, David B., Pittsford New York 14534 (US); Scheske, Siegried R., Pavilion New York 14525-9104 (US); Taggi, Arthur John, Hockessin Delaware 19707 (US)
(74) Representative: Hoffmann, Benjamin

(56) References cited:
- EP-A- 0 469 735
- WO-A-01/18604

## Description

### BACKGROUND OF THE INVENTION

### FIELD OF THE INVENTION

This invention pertains to a method and apparatus for thermally developing a photosensitive element, and particularly to a method and apparatus that controls vapors and/or condensate created during thermal treating of the photosensitive element.

### DESCRIPTION OF RELATED ART

Flexographic printing plates are well known for use in printing surfaces which range from soft and easy to deform to relatively hard, such as packaging materials, e.g., cardboard, plastic films, aluminum foils, etc.. Flexographic printing plates can be prepared from photosensitive elements containing photopolymerizable compositions, such as those described in U.S. Patents 4,323,637 and 4,427,759. The photopolymerizable compositions generally comprise an elastomeric binder, at least one monomer and a photoinitiator. Photosensitive elements generally have a photopolymerizable layer interposed between a support and a coversheet or multilayer cover element. Upon imagewise exposure to actinic radiation, photopolymerization of the photopolymerizable layer occurs in the exposed areas, thereby curing and rendering insoluble the exposed areas of the layer. Conventionally, the element is treated with a suitable solution, e.g., solvent or aqueous-based washout, to remove the unexposed areas of the photopolymerizable layer leaving a printing relief which can be used for flexographic printing. However, developing systems that treat the element with a solution are time consuming since drying for an extended period (0.5 to 24 hours) is necessary to remove absorbed developer solution.

As an alternative to solution development, a "dry" thermal development process may be used which removes the unexposed areas without the subsequent time-consuming drying step. In a thermal development process, the photosensitive layer, which has been imagewise exposed to actinic radiation, is contacted with an absorbent material at a temperature sufficient to cause the composition in the unexposed portions of the photosensitive layer to soften or melt and flow into an absorbent material. See U.S. Patents 3,060,023 (Burg et al.); 3,264,103 (Cohen et al.); 5,015,556 (Martens); 5,175,072 (Martens); 5,215,859 (Martens); and 5,279,697 (Peterson et al.). The exposed portions of the photosensitive layer remain hard, that is do not soften or melt, at the softening temperature for the unexposed portions. The absorbent material collects the softened un-irradiated material and then is separated/removed from the photosensitive layer. The cycle of heating and contacting the photosensitive layer may need to be repeated several times in order to sufficiently remove the flowable composition from the unirradiated areas and form a relief structure suitable for printing. After such processing, there remains a raised relief structure of irradiated, hardened composition that represents the irradiated image.

Photosensitive compositions may contain one or more components that can vaporize or volatilize when the element is heated to the temperature or temperatures necessary for thermal development to occur. The components that can vaporize or volatilize are generally low molecular weight compounds including monomer. The vapor can condense within a thermal development processor and drip uncontrolled onto different areas of the processor creating a mess within the processor. The formation of condensate in the processor typically depends on usage, with high volume and large plate size being contributing factors. Thus, the vapor and/or condensate from the vapor that remain inside the processor make it difficult to maintain the cleanliness and operation of the processor, and ultimately can damage the thermal development apparatus.

Also, the photosensitive elements that are being developed in the processor can be damaged by the condensate, particularly when the condensate drips onto an image area of the element. Condensate dripping onto these areas causes disturbances in the surface of the element that can render the surface unsuitable for printing.

Processors for thermal development of flexographic printing elements are known. U.S. 5,279,697 describes an automated process and apparatus for handling an irradiated printing element and accomplishing repeated heating and pressing to remove the unirradiated composition from the element. The patent indicates that certain compositions emit fumes during heat processing and are less suitable. However, the patent did not address the problem of emitted fumes during heat processing.

WO 2001/18604 describes a method and apparatus for thermal processing a photosensitive element. The thermal development apparatus is ventilated by a vacuum fan unit which controls fumes resulting from heating the composition layer. The exhaust from the vacuum fan unit is vented through a conduit. Along a bottom of a plenum associated with the vacuum fan unit is a plurality of inlets. The inlets are located above a development nip where the photosensitive element is heated and contacted with the absorbent material. Although not specifically shown or described, room temperature air enters the apparatus at or near a floor of the apparatus and in other locations. Additional air may be introduced into the apparatus with a means for cooling the photosensitive element, e.g., a blower, in proximity to the development nip. The vacuum fan unit pulls air circulating through the apparatus, including the vapor, to the exhaust conduit.

A commercial embodiment of the apparatus represented by this disclosure also includes a collection pan to collect condensate before the vacuum fan unit exhausts the vapor. The collection pan is located underneath the vacuum fan unit adjacent the exhaust conduit. In some embodiments the collection pan includes a drain that continuously drains condensate into an exterior container, or the pan includes a drain that can be opened and drained manually. For environmental reasons, it is desirable that the vapor is extracted from the air prior to exhausting the air from the processor, but vapor may escape with the exhaust air. It is also desirable that the extracted vapor condense and collect into the pan. However, the vapor has a tendency to condense prior to reaching the pan, causing dripping inside the unit.

Another approach to dealing with vapor creation during thermal development of certain compositions is addressed in WO 98/13730 which discloses a process for producing a multilayer, flexible photosensitive plate. A second layer of the multilayer element is made of a photosensitive elastomeric composition having no more than 1% by weight of ethylenically unsaturated compolymerizable compounds with molecular weights less than 500. Limiting the amount of low molecular weight compounds in the composition reduces the amount of volatiles that are emitted during thermal development. This approach however limits the photosensitive elements that can be thermally processed and thus restricts the customer in the types of plates that can be made.

So a problem arises during thermal development of photosensitive elements in that vapor and condensate from the vapor are generated. Exhaust systems in thermal development processors in the prior art either do not address the problem or have only limited success in managing the vapor and condensate in the processor. The uncontrolled presence of the vapor and/or condensate can make maintaining the cleanliness and the operation of the processor difficult, and can ultimately result in damaging the thermal development processor. Also, uncontrolled dripping of the condensate in the processor can damage the photosensitive element to the extent that it cannot be used for printing.

### SUMMARY OF THE INVENTION

The present invention provides a method for forming a relief pattern from a photosensitive element containing a composition layer having an exterior surface and capable of being partially liquefied. The method comprises supplying an absorbent material to the exterior surface of the composition with a first member, supporting the photosensitive element with a second member and heating the exterior surface of the composition layer at a heating station to a temperature Tr sufficient to cause a portion of the layer to liquefy and cause one or more components in the layer to form a vapor contacting the photosensitive element with the absorbent material to allow at least a portion of the liquefied material of the composition layer to be absorbed by the absorbent material, wherein the heating station is at or adjacent to the contacting with the absorbent material; and collecting the vapor at the heating station characterised in that at least one collection member collects the vapor as the vapor emits from the composition layer at the photosensitive element, the at least one collection member being placed at or adjacent to where the exterior surface at the photosensitive element contacts the absorbent material.

The invention also provides an apparatus for forming a relief pattern from a photosensitive element containing a composition layer having an exterior surface and capable of being partially liquefied. The apparatus comprises means for supplying an absorbent material to the exterior surface of the composition layer;
means for supporting the photosensitive element, wherein at least one of the means for supplying and the means for supporting are movable relative to the other;
means for heating the exterior surface of the composition layer to a temperature Tr sufficient to cause a portion of the layer to liquefy and cause one or more components in the layer to form a vapor;
means for collecting the vapor at or adjacent to the heating means; and

means for contacting the photosensitive element with the absorbent material to allow at least a portion of the liquefied material of the composition layer to be absorbed by the absorbent material,
wherein the heating means is at or adjacent to the contacting with the absorbent material,
characterised in that
the apparatus comprises at least one collection member placed at or adjacent to where the exterior surface of the photosensitive element contacts the absorbent material.

### BRIEF DESCRIPTION OF THE DRAWINGS

Figure 1 is a schematic cross-sectional side view of a thermal development apparatus depicting an embodiment of the present invention for controlling vapor and/or condensate generated by heating a photosensitive element.
Figure 2 is a schematic cross-sectional view of an embodiment of a separation unit for separating the vapor from air.

### DESCRIPTION OF THE PREFERRED EMBODIMENT(S)

The present invention is an apparatus as set out in present claim 28, and a method as set out in present claim 1, for thermally developing a photosensitive element containing a composition layer capable of being partially liquefied, preferably to form a flexographic printing form. The apparatus heats the composition layer to a temperature sufficient to melt at least a portion of the layer. In particular, the present invention relates to an apparatus and process for controlling vapor and/or condensate from the vapor that is generated during thermal development of the photosensitive element.

Thermal development heats the photosensitive element to a development temperature that causes uncured portions of the composition layer to liquefy, i.e., melt or soften or flow, and be carried away by contact with an absorbent material. Cured portions of the photosensitive layer have a higher melting temperature than the uncured portions and therefore do not melt, soften, or flow at the thermal development temperatures. Thermal development of photosensitive elements to form flexographic printing plates is described in U.S. 5,015,556; U.S. 5,175,072; U.S. 5,215,859; and WO 98/13730. The photosensitive element includes a substrate and at least a composition layer mounted on the substrate. The composition layer is capable of being partially liquefied.

The term "melt" is used to describe the behavior of the unirradiated portions of the composition layer subjected to an elevated temperature that softens and reduces the viscosity to permit absorption by the absorbent material. The material of the meltable portion of the composition layer is usually a viscoelastic material which does not have a sharp transition between a solid and a liquid, so the process functions to absorb the heated composition layer at any temperature above some threshold for absorption in the absorbent material. A wide temperature range may be utilized to "melt" the composition layer for the purposes of this invention. Absorption may be slower at lower temperatures and faster at higher temperatures during successful operation of the process. Similarly, there may be less vaporization of components in the photosensitive layer at lower development temperatures and greater vaporization (which can be characterized by the amount of vapor formed and/or in the number of components that vaporize) at higher development temperatures.

An apparatus suitable for thermally developing the photosensitive element is disclosed by U.S. Patent 5,279,697, and also by Johnson et al. in Patent Cooperation Treaty Publication No. WO 01/18604 A2. Although these patent publications depict that the photosensitive element is preferably placed on a drum for thermal treatment, it should be understood that the element could be placed on a planar surface for treatment. It should also be understood that one of ordinary skill in the art could modify the disclosed apparatus to accommodate mounting of the photosensitive element in the form of a cylinder or a sleeve on the drum.

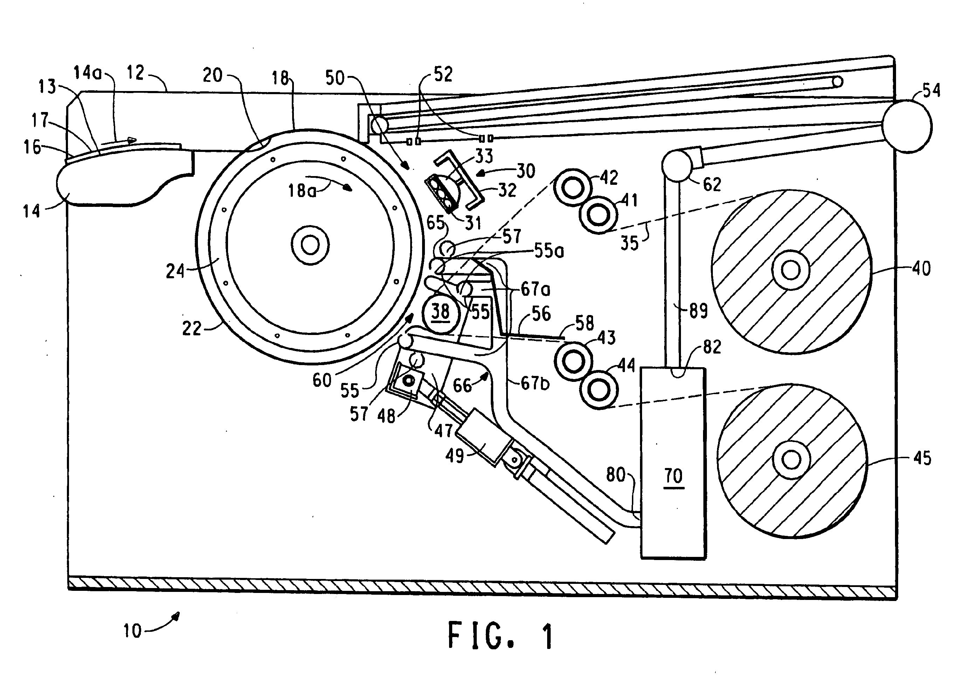

Figure 1 shows an embodiment of a thermal processor 10. A drum 18 is mounted for rotation on a stationary support frame12 and rotates in a counterclockwise direction as indicated by arrow 18a. A photosensitive element 16 is placed on a surface 13 of feed tray 14 and is urged in a direction indicated by arrow 14a. The drum 18 includes a clamp 20 that captures a leading edge of the photosensitive element 16 to mount the element 16 onto the drum. The element 16 remains substantially in contact with an outer surface 22 of the drum 18 during processing.

In the present invention, thermal development includes heating of an exterior surface 17 of the composition layer of the photosensitive element 16 to a temperature Tr sufficient to cause a portion of the layer to liquefy at temperature Tr. The at least one photosensitive layer (and additional layer/s if present) can be heated by conduction, convection, radiation or other heating methods to a temperature sufficient to effect melting of the uncured portions but not so high as to effect distortion of the cured portions of the layer. One or more additional layers disposed above the composition layer may soften or melt or flow and be absorbed as well by an absorbent material. The photosensitive element is heated to a surface temperature above about 40 °C, preferably from about 40 °C to about 230 °C (104-446 °F) in order to effect melting or flowing of the uncured portions of the composition layer. The thermal treating steps of heating the photosensitive element 16 and contacting an outermost surface of the element with an absorbent material can be done at the same time, or in sequence provided that the uncured portions of the photopolymerizable layer are still soft or in a melt state when contacted with the absorbent material.

The drum 18 may be equipped with a heater 24, which is provided to keep the photosensitive element 16 at a stable starting temperature independent of the surrounding environment. Any means of heating the drum 18 is acceptable, as long as the power capacity of the heater is sufficient to maintain a fairly constant selected skin temperature on the outer surface 22 of the drum 18 of about 50-150 °F (10-65.6 °C), preferably 75 to 95 °F (23.9-35 °C). The means for heating the drum is capable of heating the drum 18 to a temperature capable of heating the exterior surface 17 of the composition layer to a temperature T3. The heater 24 may be an electrical heating blanket, such as a wire wound blanket. If the normal operating environment is carefully controlled to be at a constant temperature, the heater can be turned off or omitted from the apparatus. As is disclosed in WO 2001/18604, it is also possible that the drum be cooled by cooling means, such as, a blower directing a stream of air at the surface of the photosensitive element and the drum and/or by the circulating of cooling fluid beneath the surface of the drum to cool the support side of the element.

Located adjacent the drum 18 is a first heating means comprising a heater 30 which, in the embodiment illustrated, is a focused radiant heater directed at an exterior surface 17 of the photosensitive element 16 on the drum 18. The heater 30 elevates the temperature of the exterior surface 17 of the composition layer to a temperature T1. In one embodiment, the heater 30 elevates the temperature of the surface 17 of the composition layer to a temperature Tr sufficient to melt the unirradiated portion of the composition layer, causing a portion of the layer to liquefy. The heater 30 is a type of heater that does not appreciably heat the substrate 15 supporting the composition layer. The heater 30 applies heat to the exterior surface 17 of the composition layer. In the embodiment illustrated, the heater 30 comprises a plurality of tubular infrared heating bulbs, such as bulbs 31 mounted in end supports, such as support 32, that also provide electrical connections to the bulbs 31. Adjacent the side of the bulbs 31 opposite drum 18 is a reflector 33 that acts to focus and direct the infrared radiation toward the exterior surface 17 of the photosensitive element sheet 16. An alternate embodiment of the heater 30 uses one tubular infrared heating bulb 31 mounted in the end supports 32 with the reflector 33.

The thermal processor 10 includes a delivery means for feeding a continuous web 35 of absorbent material, which in the preferred embodiment contacts a hot roller 38. A second means for heating includes the hot roller 38. The hot roller 38 is positioned adjacent the drum 18 which carries the photosensitive element 16. The hot roller 38 is also adjacent the heater 30, and the hot roller 38 maintains or further elevates the temperature of the exterior surface 17 of the composition layer to temperature T2. The hot roller 38 applies heat to the exterior surface 17 of the photosensitive element 16. The absorbent web 35 is unwound from a supply roll 40 and passes between rolls 41 and 42 in a serpentine path. The web 35 is then guided over the hot roller 38 and over rolls 43 and 44. One or more of the rolls 41, 42, 43, 44, or 45 drive the web 35. One or more of the rolls 40, 41, 42, 43, 44 may include a braking mechanism to maintain tension of the web in its transport path. The web 35 is then wound up on take up roll 45.

The processor 10 is provided with a means for relative motion between the drum 18 and the hot roller 38, so that the photosensitive element 16 and the web 35 of absorbent material can be brought into contact with the other. Means for providing relative movement can be accomplished, for example, by mounting the hot roller 38 (and/or drum 18) onto arms 47 attached to a beam 48 that moves the hot roller 35 under the urging of one or more actuators 49. Temperature sensors may be mounted throughout the processor to monitor the temperature for the purpose of controlling the heating elements in the drum 18, hot roller 38, and radiant heater 30.

The radiant heater 30 acting as a first heating means, the hot roller 38 acting as a second heating means, and the drum heater 24 acting as a third heating means, independently or in any combination, are capable of heating the exterior surface 17 of the photosensitive element 16 to a temperature sufficient to cause a portion, i.e., an unirradiated portion, of the composition layer to liquifiy at Tr. The first heating means, the second heating means, and the third heating means independently or in any combination constitute a heating station 50. A preferred heating station 50 includes the first heating means and the second heating means.

The processor 10 may also include a heat management system for controlling the heat generated by thermal development. Outlets 52 are positioned above the heat station 50 to direct heated air out of the interior of the processor but are sufficiently far removed to minimize the chance of capturing vapor into the heat management system. The heated air exits the processor 10 through the exhaust 54.

Heating the composition layer to a temperature Tr sufficient to cause a portion of the layer to liquefy at the heating station 50 can also cause one or more components in the layer to form a vapor. The vapor formed by heating of the photosensitive element 16 is composed primarily of monomer or monomers in the composition layer. The vapor can also be formed from volatilization of other low molecular weight organic compounds that are present in the composition layer. In addition, it is possible that one or more components from additional layers on the composition layer may form a vapor upon heating.

In the present invention, the vapor formed at the heating station 50 during thermal development is controlled in order not to disturb the relief surfaces of the photosensitive element 16 currently being developed as well as the photosensitive elements 16 which subsequently enter the process. Controlling the vapor formed during thermal development will also improve the cleanliness and operation of the thermal processor. Means for controlling the vapor generated by heating the photosensitive element 16 includes means for collecting the vapor during heating, means for confining the vapor, and means for managing the removal of the confined vapor. The means for controlling the vapor generated by heating the photosensitive element 16 and any condensate formed from the vapor constitutes a vapor-condensate management system.

Controlling of the vapor generated during thermal development begins by collecting the vapor at or adjacent to where the photosensitive element 16 is being heated, that is, at the heating station 50. At least one collection member 55 collects the vapor as the vapor emits from the composition layer of the photosensitive element 16. The at least one collection member 55 is a means for collecting the vapor. The collection member 55 is positioned at the heating station 50 to collect as much of the vapor as it forms, and as such can be positioned anyplace in a region in and surrounding the heating station 50. Since vapor is most likely to form when the composition layer is reaching or reaches the temperature Tr to liquefy, the at least one collection member 55 is placed at or adjacent to a nip 60 where the exterior surface 17 of the photosensitive element 16 contacts the absorbent web 35. The at least one collection member 55 is adjacent to the hot roller 38 and the drum 18. The at least one collection member 55 is supported in the processor 10 by mounting brackets secured to the frame 12 or a side wall or an interior wall of the processor 10. The at least one collection member 55 is stationary and do not move with the hot roller 38 when the roller 38 is urged toward the drum 18.

In the embodiment shown in Figure 1, there are 3 collection members 55 at the heating station 50 that are spaced about the hot roller 38 with at least one collection member 55 on each side of the nip 60. The at least one collection member 55 is parallel or substantially parallel to a longitudinal axis of the hot roller 38 and the same or substantially the same axial length as the hot roller 38. The at least one collection member 55 is a tube having a plurality of openings or one or more axial slots 55a for intaking the air containing the vapor. The collection member or members 55 may also be identified as a manifold. The vapor is drawn into the at least one collecting member 55 by a vacuum fan 62 that is ultimately connected to the means for controlling the vapor near the exhaust 54 of the processor 10. The exhaust fan 62 would be turned on when the processor begins operation, and would remain on through the development, i.e., for the total number of cycles of heating and contacting, of the photosensitive element 16. The fan may also run, preferably at low speed, during idle periods to capture any vapor from heating or maintaining the standby temperature inside the processor.

The means for collecting vapor can include a shroud 56 that isolates or substantially isolates the air with the vapor at the heating station 50 region from the remainder of the interior environment of the processor 10. The shroud 56 is located on a backside of the hot roller 38 opposite the drum 18 to substantially enclose the at least one collection member 55 at the heating station 50. The shroud 56 helps to keep the air with the vapor in the heating station 50 region, so that the at least one collection members 55 can collect the vapor before the vapor escapes to other environs of the processor 10. In the embodiment shown, an end 58 of the shroud 56 is extended along the path of the absorbent web 35 after the web has contacted the hot roller 38. Thus the shroud 56 covers the web 35 while the web is still hot and helps to isolate vapor as vapor can continue to emit from the uncured portions of the composition layer that are carried away in the web. In an alternate embodiment, multiple shrouds 56 could be placed around the at least one collection members 55. In another alternate embodiment, a box-like shroud could be located around the collecting member or members 55, with openings to allow the absorbent web 35 to enter and leave, and at the nip between the hot roller 38 and the drum 18.

The means for collecting vapor can further include a supply of air 57 at the heating station 50, near or adjacent to the at least one collection members 55. The supply of air 57, which may also be called an air knife or an air curtain serves to contain and direct the vapor toward the at least one collection members 55. The air curtain 57 is one or more tubular members each of which parallels or substantially parallels the adjacent collection member 55. The tubular members each have a plurality of openings that supply the air to the heating station 50. Preferably, the air curtain 57 supplies air via the tubular member at each of the collection members 55 located prior to and after the nip 60. The air supplied by the air curtain 57 is typically less than 10% of the total air removed by the at least one collection member 55, preferably less than 5%. Air can be supplied from any convenient source of pressurized air, such as, for example, a compressed air line, a dedicated blower, or a side stream from a larger blower. It is also contemplated that the supply of air 57 can be provided by redirecting a small stream of air from the exhaust fan 62 to the at least one tubular members, thereby recirculating a portion of the air from the exhaust 54. Preferably, the supply of air 57 is from a compressed air line having a regulator to control the pressure of the air supplied. It should be understood that a stream of any type of gas can be supplied instead of air, provided that that the gas is inert to the conditions in the processor. Air is preferred due to its ready availability.

In one embodiment, the means for collecting the vapor captures all or a majority of the vapor as it is generated. It is possible that only some of the vapor may be collected with the present invention and the remainder of the vapor removed with the exhaust 54. In this case, the means for controlling the vapor should capture enough of the vapor so that the exhaust from the processor 10 and the associated dilution of the remaining vapor not reach a saturated condition at any point in the process or risk condensation in an undesired location.

Controlling the vapors also includes a means for confining the vapor while inside the processor 10. In the embodiment shown in Figure 1, a first end 65 of all of the collection members 55 each connect to the means for confining the vapor. The means for confining the vapor is a series of interconnected conduits 66 that direct the vapor from the collection member/s 55 to a means for managing the removal of the vapor. The collected vapor is contained and directed through the series of interconnected conduits 66 to the means for managing the removal of the vapor by the vacuum fan 62. The first end 65 of the collection member 55 is connected to a first conduit 67a which in turn is connected to a second conduit 67b. In one embodiment, only one end 65 of the collection member 55 connects to the means for confining the vapor. In an alternate embodiment, a second end of the collection member 55 (coming out of the plane of the processor cross-section) can similarly connect to a series of interconnected conduits 66 that direct the vapor from the collection member to the means for managing the removal of the vapor.

After collection, while in the collection member/s 55 or in the conduits 66, the vapor may cool or be cooled such that one or more of the components in the vapor condenses to a liquid or liquid-like form. If the vapor cools while in the collection member/s 55 and forms condensate, moving air carries the condensate to the means for managing the vapor removal. The means for confining the vapor thus may also confine the condensate as it is generated. In the embodiment shown, the first conduits 67a are connect to the second conduit 67b which is oriented vertically or substantially vertically so that, if the vapor condenses, the condensate flows under gravity toward the means for managing the removal of vapor. Cooling may occur naturally as the air with vapor is transported away from the heating station 50 through the collection member 55 and the conduits 66. Or the vapor may be cooled by a heat exchanger, such as, for example, a condenser, as part of or prior to the means for managing the removal of the vapor.

Alternatively, the means for confining the vapor may be heated with for example, an electrical wire wrapped about one or more of the first and second conduits 67a, 67b. Heating the means for confining maintains the vapor in its vaporized state for removal from the processor 10, preferably by the means for managing the removal of the vapor. It is also contemplated that the vapor, heated or unheated, may be transported through the conduits 66 directly to the exhaust 54. If the vapor goes directly to the exhaust 54, the removal of the vapor from the air can be conducted external to the processor in an exhaust system, such as industrial vacuums sold by DuroVac Industrial Vacuums in Ontario, Canada, and Nikro Industries, Inc., in Villa Park, Illinois.

Controlling the vapor includes managing the removal of the vapor from the processor. If condensate is present, the means for managing also manages the removal of the condensate. An end of the second conduit 67b, opposite the conduit 67a connected to the collection member 55, is connected to the means for managing the removal of the vapor. The means for managing the removal of the vapor includes a separation unit 70.

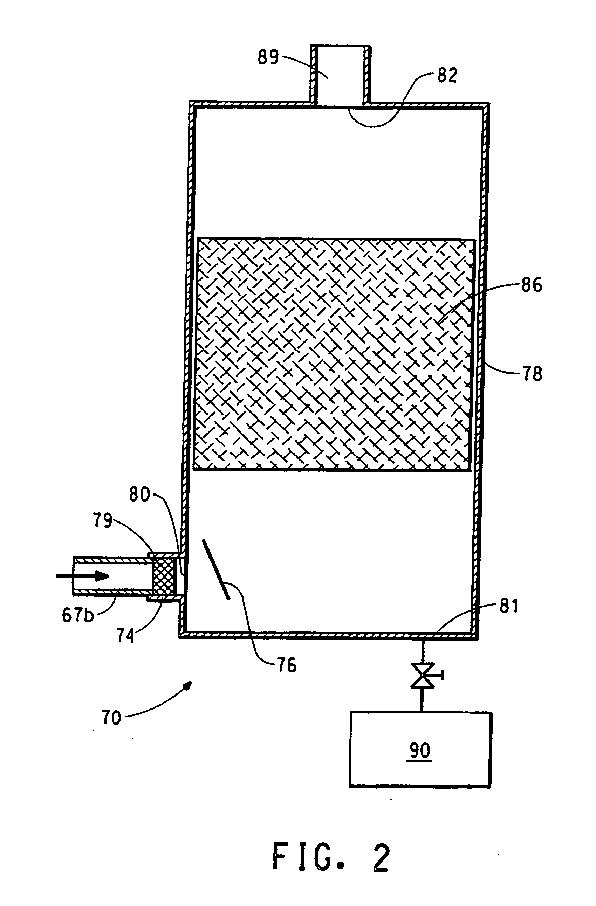

Figure 2 shows an embodiment of the separation unit 70 suitable to manage the removal of vapor, vapor and condensate, or condensate from the air. The separation unit 70 includes a coalescing unit 74, an impingement surface 76, and a separation chamber 78. Prior to entering the separation unit 70, typically the vapor has cooled sufficiently to begin condensing and forming very small droplets. The coalescing unit 74 causes the very small droplets to collect and coalesce into larger drops of condensate that can more readily be separated from the moving air stream. The coalescing unit 74 is mesh 79 encased at the end of the conduit 67b at or in an entrance 80 to the separation unit 70. Condensate, if present from cooling in the conduits 66 or if formed in the coalesing unit 74, passes through the mesh 79 and collects at a bottom 81 of the separation chamber 78. The impingement surface 76 is a plate-like member that is mounted to the inside of the separation chamber 78 in a position near the entrance 80 of the separation unit 70 so that the air containing small drops or droplets from the coalescing unit 74 strikes the surface 76. The plate-like member may be embossed or etched or modified to provide the impingement surface 76 with a pattern to aid in the collection of vapor into condensate as drops. In one embodiment, the pattern is a series of chevron vanes that appear like two "W"s stacked on top of one another. But it is conceivable that any pattern can be included on the impingement surface 75 to induce drop formation. The drops and droplets collect on the impingement surface 76 and drip to the bottom 81 of the separation chamber 78.

It is also contemplated to combine the coalescing and separating functions into a single unit using a coalescing filter cartridge array as is known in the art for separating liquid droplets from gas streams. The design of such a filter cartridge array is dependent on the particulars of the gas velocity and the space available inside the processor for mounting such hardware. The coalescing filter cartridge array may be preferred particularly when the vapor air stream contains significant amounts of very fine droplets of condensate. Alternatively, the coalescing filter cartridge array as a separation unit 70 could be located external to the processor.

The separation chamber 78 removes the finer droplets of vapor which were not removed by the coalescing unit 74 and/or the impingement surface 76 from the air. The separation chamber 78 can use any conventional liquid-vapor separation methods to remove the vapor from the air. In one embodiment, an area above the impingement surface 76 in the separation chamber 78 can be packed with a disposable filtration media 86 that accumulates condensate liquid formed from the vapor. In another embodiment, the area above the impingement surface 76 in the separation chamber 78 is packed with a draining media 86 that does not saturate with the condensate but causes the vapor to collect as liquid and drain from the media to the bottom 81 of the separation chamber 78. Either of these two embodiments is shown in Figure 2. In yet another embodiment, the air with the vapor can be directed to a cyclone separator that creates a circulating flow in which the condensate drops are flung to impinge upon an interior wall of the separator where the collect and drain from the separator.

After all or substantially all of the liquid is removed from the air, the air (and any remaining vapor) exits the separation chamber 78 through opening 82, travels through a conduit 89 to the vacuum fan 62, and vents from the processor 10 in the exhaust 54. In order to reduce the chances of any remaining vapor condensing in the air after leaving the separation chamber 78, it is contemplated that additional air may be introduced into the conduit 89 before or after the vacuum fan 62 thereby diluting the vapor in the air. An external exhaust system, such as an external filter, may be connected to the exhaust 54 to conduct a final removal of vapor from the air prior to sending the air to the outside environment.

If there are small entrained droplets of condensate remaining in the exhaust air, it is preferred to ensure that the air flow is smooth, that is, a non-recirculating flow of air where there are no or minimal areas of air flow at low velocity, throughout the exhaust system. Sudden expansions, contractions, or flow restrictions such as those that occur at imprecise junctions of piping systems or at a small pipe emptying into a larger pipe, can cause these entrained droplets to come out of suspension and collect in the exhaust piping. This leads to a build up of liquid condensate in undesirable locations. This problem can be avoided by keeping the air flow in the exhaust 54 confined in smooth piping, thereby minimizing the air flow disturbances. Alternatively, the exhaust sysem can include a series of sudden contractions and expansions such as a series of concentric orifices to promote the turbulent deposition of entrained droplets in the vapor at the exit. A drain line can be installed on the exhaust system to direct the collected condensate to a collection location, such as the bottom 81 of the separation chamber 78.

In areas where liquid collection is unavoidable, it may be advantageous to utilize a piping material which will absorb the condensate. Piping materials that may absorb condensate and are suitable for use include PVC, silicone, and other polymeric materials in which the condensate is soluble. Such piping will likely need to be replaceable due to the swelling or softening resulting from the absorption of the condensable species. But the relatively infrequent replacement of a pipe or pipes associated with the exhaust 54 and external to the processor 10 may be preferable to periodic cleaning of liquid residue build up in the piping. A piping material which absorbs condensate is considered a condensate absorbent material.

The condensate from the bottom 81 of the separation chamber 78 can be managed by any one or combination of the following several methods. As shown in Figure 2, the condensate may be drained from the bottom 81 of the separation chamber 78 and collected into a container 90 that is disposed in an environmentally sound manner. In another embodiment, the condensate may be pumped from the bottom 81 of the separation chamber 78 or drained into a vessel which is subsequently pressurized and then dispensed for removal from the processor 10. The condensate may be dispensed (with a pump) onto the absorbent web 35 prior to or just as the web is wound up on the take up roll 45. Alternatively, the condensate may be dispensed onto a condensate absorbent material that can be a particulate, such as clay in a collection tray, or another absorbent web or a material different than the absorbent material. Similar to condensate in exhaust 54 discussed above, the condensate from the separation chamber 78 may be delivered to or pass through a pipe that by its composition is a condensate absorbent material. The condensate absorbent material in the form of a web or fibrous-like mass may be located on a collar of the take up roll 45. In yet another embodiment, the condensate (while in the bottom 81 of the separation chamber or in a collection container) may be exposed to actinic radiation. The condensate liquid is exposed to the actinic radiation for a sufficient period of time to harden the liquid to at least a tacky state for removal from the processor 10. The condensate may also be dispensed to form a layer between oxygen impermeable or substantially oxygen impermeable films and then exposed to actinic radiation. Placing the condensate as a layer between oxygen impermeable films minimizes the presence of oxygen during exposure of the condensate so that the condensate will sufficiently cure in a relatively short period of time. Ultraviolet lamp/s may be used to expose the condensate and cure the liquefied condensate. Such UV lamps can be obtained from Voltarc Technologies, Inc., located in Fairfield, CT; Philips Corp., via a distributor Bulbtronics located in Famingdale, NY.

The at least one collection member 55, the conduits 66, and the separation unit 70 can be made of any material suitable for use provided that they not soften, dissolve, react, or corrode under the operating conditions of the processor or upon contact with the vapor or condensate. In one preferred embodiment the collection members 55, the conduits 66, and the separation unit 70 are made of stainless steel. Under certain circumstances it may be desireable to use a material for one or more of the components in the vapor-condensate management system internal to the processor 10 that will absorb the condensate, as was described above relative to the exhaust 54 and exhaust piping. Even though materials that absorb the condensate will likely soften with use, these materials can be used in areas of the system which are easily replaced, preferably downstream of the separation unit 70.

Advantageously, the method and apparatus of the present invention provides a means for controlling vapor and/or condensate generated from the vapor in thermal development of a photosensitive element. The present invention controls the conversion of the vapor into condensate such that the condensate can be easily captured and removed from the apparatus. Additionally, the condensate can be removed in liquid or even solid form from the processor rather than exhausting the vapor or aerosol from the apparatus for subsequent treatment.

### Photosensitive Element

The photosensitive element used in the present invention is not limited to the type of element that is thermally processed, provided that the element generates a vapor upon heating. In one embodiment, the element is a photosensitive element 16 that includes a flexible substrate and a composition layer mounted on the substrate. The composition layer is at least one layer on the substrate capable of being partially liquefied. Preferably, the photosensitive element 16 is an elastomeric printing element suitable for use as a flexographic printing form. The at least one layer on the substrate is preferably a photosensitive layer, and most preferably a photopolymerizable layer of an elastomeric composition wherein the photosensitive layer can be selectively cured by actinic radiation. As used herein, the term "photopolymerizable" encompasses systems which are photopolymerizable, photocrosslinkable, or both. In cases where the composition layer comprises more than one photosensitive layer on the flexible substrate, the composition of each of the photosensitive layers can be the same or different from any of the other photosensitive layers.

The layer of the photosensitive composition is capable of partially liquefying upon thermal development. That is, during thermal development the uncured composition must soften or melt at a reasonable processing or developing temperature. Heating the exterior surface of the composition layer to a temperature Tr sufficient to cause a portion of the layer to liquefy also can cause one or more components in the layer to form a vapor.

The photosensitive layer includes at least one monomer and a photoinitiator, and optionally a binder. The at least one monomer is an addition-polymerizable ethylenically unsaturated compound with at least one terminal ethylenic group. Monomers that can be used in the photosensitive layer are well known in the art and include monofunctional acrylates and methacrylates, multifunctional acrylates and methacrylates, and polyacryloyl oligomers. Examples of monomers include, but are not limited to, ethylene glycol diacrylate, hexanediol diacrylate, diethylene glycol diacrylate, glycerol diacrylate, trimethylol propane triacrylate, hexanediol dimethacrylate, glycerol triacrylate, trimethylolpropane triacrylate, ethylene glycol dimethacrylate, 1,3-propanediol dimethacrylate, 1,2,4-butanetrioltrimethacrylate, and 1,4-butanediol diacrylate. Further examples of monomers can be found in U.S. Patents 4,323,636; 4,753,865; and 4,726,877. A mixture of monomers may be used.

The photoinitiator is a compound that generates free radicals upon exposure to actinic radiation. Any of the known classes of photoinitiators, particularly free radical photoinitiators such as quinones, benzophenones, benzoin ethers, aryl ketones, peroxides, biimidazoles, diaryliodoniums, triarylsulfoniums, and phosphoniums, and diazoniums, may be used. Alternatively, the photoinitiator may be a mixture of compounds, one of which provides the free radicals when caused to do so by a sensitizer activated by radiation.

The optional binder is a preformed polymer that serves as a matrix for the monomer and photoinitiator prior to exposure and is a contributor to the physical properties of the photopolymer both before and after exposure. In one embodiment the optional binder is elastomeric. A nonlimiting example of an elastomeric binder is an A-B-A type block copolymer, where A represents a nonelastomeric block, preferably a vinyl polymer and most preferably polystyrene, and B represents an elastomeric block, preferably polybutadiene or polyisoprene. Other suitable photosensitive elastomers that may be used include polyurethane elastomers, such as those described in U.S. Patent Nos. 5,015,556 and 5,175, 072. The monomer or mixture of monomers must be compatible with the binder to the extent that a clear, non-cloudy photosensitive layer is produced.

Additional additives to the photosensitive layer include colorants, processing aids, antioxidants, and antiozonants. Processing aids may be such things as low molecular weight polymers compatible with the elastomeric block copolymer. Antiozonants include hydrocarbon waxes, norbornenes, and vegetable oils. Suitable antioxidants include alkylated phenols, alkylated bisphenols, polymerized trimethyldihydroquinone, and dilauryl thiopropinoate.

The photosensitive element may include one or more additional layers on the side of the photosensitive layer opposite the substrate. Examples of additional layers include, but are not limited to, a release layer, a capping layer, an elastomeric layer, a laser radiation-sensitive layer, a barrier layer, and combinations thereof. The one or more additional layers preferably are removeable, in whole or in part, by contact with an absorbent material in the range of acceptable developing temperatures for the photosensitive element used. One or more of the additional other layers can cover or only partially cover the photosensitive composition layer. An example of an additional layer which only partially covers the photosensitive composition layer is a masking layer that is formed by imagewise application, e.g., ink jet application, of an actinic radiation blocking material or ink.

The release layer protects the surface of the composition layer and enables the easy removal of a mask used for the imagewise exposure of the photosensitive element. Materials suitable for the release layer are well known in the art, with polyamides, polyvinyl alcohol, hydroxyalkyl cellulose, and amphoteric interpolymers and combinations thereof being preferred. Suitable compositions for the capping layer and methods for forming the layer on the element are disclosed as elastomeric compositions in a multilayer cover element described in Gruetzmacher et al., U.S. Patent Nos. 4,427,759 and 4,460,675. The elastomeric capping layer is similar to the photosensitive layer in that after imagewise exposure the elastomeric capping layer is at least partially removable by contact with an absorbent material in the range of acceptable temperatures for the photosensitive element used.

In one embodiment, the laser radiation sensitive layer is sensitive to infrared laser radiation, and thus may be identified as an infrared-sensitive layer. The laser radiation sensitive layer can be on the photosensitive layer, or on a barrier layer which is on the photosensitive layer, or on a temporary support which together with the photosensitive element form an assemblage. Each of the release layer and elastomeric capping layer can function as the barrier layer when the release and/or capping layer/s is disposed between the infrared-sensitive layer and the photosensitive layer. The infrared-sensitive layer can be ablated (i.e., vaporized or removed) from the photosensitive layer on the side opposite the flexible substrate by exposure to infrared laser radiation. Alternatively, when the photosensitive element forms an assemblage with the support carrying the infrared-sensitive layer, the infrared-sensitive layer can be transferred from the temporary support to the external surface (the side opposite the flexible substrate) of the photosensitive layer by exposure to infrared laser radiation. The infrared-sensitive layer can be used alone or with other layers, e.g., ejection layer, heating layer, etc.

The infrared-sensitive layer generally comprises an infrared-absorbing material, a radiation-opaque material, and an optional binder. Dark inorganic pigments, such as carbon black and graphite, generally function as both infrared-sensitive material and radiation-opaque material. The thickness of the infrared-sensitive layer should be in a range to optimize both sensitivity and opacity to actinic radiation (e.g., has an optical density of ≥ 2.5). Such infrared-sensitive photoablative or phototransferable layer can be employed in digital direct-to-plate image technology in which the exposure by laser radiation removes or transfers the infrared-sensitive layer to form an in-situ mask on the photosensitive element. Suitable infrared-sensitive compositions, elements, and their preparation are disclosed in U.S. Patent 5,262,275; U.S. Patent 5,719,009; U. S. 5,607,814; U.S. Patent No. 5,506,086; U.S. Patent 5,766,819; U.S. Patent 5,840,463; and EP 0 741 330 A1. The infrared-sensitive layer preferably is removable by contact with an absorbent material in the range of acceptable developing temperatures for the photosensitive element used.

The photosensitive element used in the present invention may further include a temporary coversheet on top of the uppermost layer of the photosensitive element. One purpose of the coversheet is to protect the uppermost layer of the photosensitive element during storage and handling. Depending upon end use, the coversheet may or may not be removed prior to imaging, but is removed prior to development. Examples of suitable materials for the coversheet include thin films of polystyrene, polyethylene, polypropylene, polycarbonate, fluoropolymers, polyamide or polyesters.

The substrate is selected to be tear resistant and must have a fairly high melt point, for example, above the melt temperature of the composition layer formed on the substrate. The material for the substrate is not limited and can be selected from polymeric films, foams, fabrics, and metals such as aluminum and steel. The substrate can be almost any polymeric material that forms films that are non-reactive and remain stable throughout the processing conditions. Examples of suitable film supports include cellulosic films and thermoplastic materials such as polyolefins, polycarbonates, and polyester. Linear polyesters are preferred, particularly polyethylene terephthalate (PET).

The substrate of the photosensitive element has a thickness of between about 0.01 mm and about 0.38 mm. The radiation curable composition layer is between about 0.35 mm and about 7.6 mm thick, with a preferred thickness of about 0.5 mm to 3.9 mm (20 to 155 mils).

The photosensitive element 16 is prepared for thermal development by imagewise exposing the element 16 to actinic radiation. After imagewise exposure, the photosensitive element 16 contains cured portions in the exposed areas of the radiation curable composition layer and uncured portions in the unexposed areas of the radiation curable composition layer. Imagewise exposure is carried out by exposing the photosensitive element through an image-bearing mask. The image-bearing mask may be a black and white transparency or negative containing the subject matter to be printed, or an in-situ mask formed with the laser radiation sensitive layer on the composition layer, or other means known in the art. Imagewise exposure can be carried out in a vacuum frame or may be conducted in the presence of atmospheric oxygen. On exposure, the transparent areas of the mask allow addition polymerization or crosslinking to take place, while the actinic radiation opaque areas remain uncrosslinked. Exposure is of sufficient duration to crosslink the exposed areas down to the support or to a back exposed layer (floor). Imagewise exposure time is typically much longer than backflash time, and ranges from a few to tens of minutes.

For direct-to-plate image formation as disclosed in U.S. Patent 5,262,275;U.S. Patent 5,719,009; U. S. 5,607,814; U.S. Patent No. 5,506,086; U.S. Patent 5,766,819; U.S. Patent 5,840,463 and EP 0 741 330 A1 the image-bearing mask is formed in-situ with the laser radiation sensitive layer using an infrared laser exposure engine. The imagewise laser exposure can be carried out using various types of infrared lasers, which emit in the range 750 to 20,000 nm, preferably in the range 780 to 2,000 nm. Diode lasers may be used, but Nd:YAG lasers emitting at 1060 nm are preferred.

Actinic radiation sources encompass the ultraviolet, visible and infrared wavelength regions. The suitability of a particular actinic radiation source is governed by the photosensitivity of the initiator and the at least one monomer used in preparing the flexographic printing plates from the photosensitive element. The preferred photosensitivity of most common flexographic printing plates are in the UV and deep visible area of the spectrum, as they afford better room-light stability. The portions of the composition layer that are exposed to radiation chemically cross-link and cure. The portions of the composition layer that are unirradiated (unexposed) are not cured and have a lower melting temperature than the cured irradiated portions. The imagewise exposed photosensitive element 16 is then ready for heat development with the absorbent material to form a relief pattern.

An overall back exposure, a so-called backflash exposure, may be conducted before or after the imagewise exposure to polymerize a predetermined thickness of the photopolymer layer adjacent the support. This polymerized portion of the photopolymer layer is designated a floor. The floor thickness varies with the time of exposure, exposure source, etc. This exposure may be done diffuse or directed. All radiation sources suitable for imagewise exposure may be used. The exposure is generally for 10 seconds to 30 minutes.

Following overall exposure to UV radiation through the mask, the photosensitive printing element is thermally developed to remove unpolymerized areas in the photopolymerizable layer and thereby form a relief image. The thermal development step removes at least the photopolymerizable layer in the areas which were not exposed to actinic radiation, i.e., the unexposed areas or uncured areas, of the photopolymerizable layer. Except for the elastomeric capping layer, typically the additional layers that may be present on the photopolymerizable layer are removed or substantially removed from the polymerized areas of the photopolymerizable layer.

The operation of the apparatus for the process of thermally developing the photosensitive element is described in reference to Figure 1. The plate processor 10 is in a home position with the drum 18 stationary with the clamp 20 positioned near the top of the drum adjacent the feed tray 14. The operator places the photosensitive element 16 on feed tray 14. An operator then opens clamp 20 and engages the leading edge 24 of the element 16 in clamp 20. The drum heater 24 or the IR heater 30 may be used to preheat the drum 18. The cartridge heater (not shown) for the hot roll 38 is used to preheat the hot roll. The drum 18 starts tuming and carries the element 16 with it. The heater 30 may preheat the bulbs 31 before the element 16 reaches the heater 30, and then switch to an operating setting to achieve the desired temperature T1 for melting the composition layer on element 16. As the leading edge 24 of the element 16 reaches the position where the hot roll 38 will contact the drum 18, the hot roll actuators 49 move the hot roll 38 carrying the absorbent web 35 against the element 16. The photosensitive element composition layer is heated to between 40 and 230°C. (104-392°F.) while in contact with the absorbent material. The absorbent material contacts the exterior surface 17 of the composition layer of the heated photosensitive element, and absorbs the liquefied portions of the elastomeric polymer from the unirradiated portions of the composition layer, forming a flexographic printing form in which portions are removed as shown to form a relief pattern or surface. At the same time, any vapor that is generated by heating of the composition layer is controlled while in the processor 10 by collecting the vapor in the at least one collection member 55. By maintaining more or less intimate contact of the absorbent material with the composition layer that is molten in the uncured regions, a transfer of the uncured photosensitive material from the photopolymerizable layer to the absorbent material takes place. While still in the heated condition, the absorbent material is separated from the cured photosensitive element 16a to reveal the relief structure.

As the trailing edge of the element 16 passes the hot roll/drum contact point, i.e., nip, the heater 30 may cool down or turn off, the actuator 49 will retract the hot roll 38, and the web 35 will be stopped. The drum 18 may return the leading edge of the element 16 to the home position to begin another cycle of heating and contacting. A cycle of the steps of heating the photopolymerizable layer and contacting the molten (portions) layer with an absorbent material can be repeated as many times as necessary to adequately remove the uncured material and create sufficient relief depth. However, it is desirable to minimize the number of cycles for suitable system performance, and typically the photopolymerizable element is thermally treated for 5 to 15 cycles. Intimate contact of the absorbent material to the photopolymerizable layer (while in the uncured portions are melt) may be maintained by the pressing the layer and the absorbent material together.

An absorbent material is selected having a melt temperature exceeding the melt temperature of the unirradiated or uncured portions of the radiation curable composition and having good tear resistance at the same operating temperatures. Preferably, the selected material withstands temperatures required to process the photosensitive element during heating. The absorbent material is selected from non-woven materials, paper stocks, fibrous woven material, open-celled foam materials, porous materials that contain more or less a substantial fraction of their included volume as void volume. The absorbent material can be in web or sheet form. The absorbent materials should also possess a high absorbency for the molten elastomeric composition as measured by the grams of elastomer that can be absorbed per square millimeter of the absorbent material. It is also desirable that fibers are bonded in an absorbent material so that the fibers are not deposited into the plate during development. A non-woven nylon web is preferred.
After thermal development, the flexographic printing form may be post exposed and/or chemically or physically after-treated in any sequence to detackify the surface of the flexographic printing form.

## Claims

1. A method for forming a relief pattern from a photosensitive element (16) containing a composition layer having an exterior surface (17) and capable of being partially liquefied, comprising:
supplying an absorbent material (35) to the exterior surface (17) of the composition layer with a first member (38);
supporting the photosensitive element with a second member (18);
heating the exterior surface of the composition layer at a heating station (50) to a temperature Tr sufficient to cause a portion of the layer to liquefy and cause one or more components in the layer to form a vapor;
contacting the photosensitive element (16) with the absorbent material (35) to allow at least a. portion of the liquefied material of the composition layer to be absorbed by the absorbent material (35) wherein the heating station (50) is at or adjacent to the contacting (60) with the absorbent material (35); and
collecting the vapor,
**characterised in that**
at least one collection membe r(55) collects the vapor as the vapor emits from the composition layer at the photosensitive element (16), the at least one collection member being placed at or adjacent to where the exterior surface (17) at the photosensitive element (16) contacts the absorbent material (35).

2. The method of Claim 1 wherein the heating step is selected from the group consisting of
a first heating which applies heat to the exterior surface (17) of the composition layer (16) adjacent where the absorbent material (35) contacts the layer (16), the first heating adapted to heat the exterior surface (17) of the layer layer (16), the first heating adapted to heat the exterior surface (17) of the layer (16) to temperature T1;
a second heating to heat the first member (38) to a temperature capable of heating the exterior surface (17) of the composition layer(16) to a temperature T2 while the absorbent material (35) is contacting the exterior surface of the layer (16);
a third heating to heat the second member (18) to a temperature capable of heating the exterior surface (17) of the composition layer (16) to a temperature T3;
a combination of the first heating and the second heating;
a combination of the first heating and the third heating;
a combination of the second heating and the third heating; and
a combination of the first heating, the second heating and the third heating.

3. The method of Claim 1 wherein the contacting step is performed by pressing the photosensitive element (16) and the absorbent material (35) into contact at a pressure sufficient for at least a portion of the liquefied material of the composition layer to be absorbed by the absorbent material.

4. The method of Claim 1 further comprising separating the photosensitive element 16 from the absorbent material (35).

5. The method of Claim 1 further comprising confining the vapor.

6. The method of Claim 5 wherein all or a portion of the vapor during or after the confining step cools or is cooled to form a condensate.

7. The method of Claim 6 wherein the confining step further comprises confining the condensate.

8. The method of Claim 6 wherein the vapor cools to form a condensate.

9. The method of Claim 6 further comprising collecting the condensate.

10. The method of Claim 5 further comprising managing removal of the vapor during or after the confining step.

11. The method of Claim 10 wherein all or a portion of the vapor cools or is cooled to form a condensate and the managing step comprises removing of the condensate.

12. The method of Claim 11 wherein the managing step further comprises separating the vapor from the condensate and collecting the condensate.

13. The method of Claim 11 wherein the managing step further comprises delivering the condensate to an absorbent material (35) that also absorbs the liquefied material of the composition layer.

14. The method of Claim 11 wherein the managing step comprises delivering the condensate to a condensate absorbent material (35).

15. The method of Claim 11 wherein the managing step further comprises exposing the condensate to actinic radiation.

16. The method of Claim 10 wherein the managing step comprises exhausting the confined vapor to an external exhaust collection system (66, 70, 89, 62, 54).

17. The method of Claim 16 further comprising maintaining a non-recirculating flow of the confined vapor in the exhaust collection system.

18. The method of Claim 16 wherein the external exhaust collection system comprises one or more parts composed of a condensate absorbent material.

19. The method of Claim 10 further comprising transporting the confined vapor through a condensate absorbent material.

20. The method of Claim 10 wherein the managing step comprises maintaining the vapor at a temperature sufficient to keep the vapor in its vaporized state for removal.

21. The method of Claim 10 wherein the managing step comprises cooling the vapor to a temperature sufficient to condense one or more of the components.

22. The method of Claim 1 further comprising shrouding the vapor at the heating station (50).

23. The method of Claim 1 wherein the photosensitive element (16) is selected from the group consisting of a sheet, a cylinder and a sheet on a sleeve.

24. The method of Claim 1 wherein the heating step generates heated air, the method further comprising removing the heated air.

25. The method of Claim 1 wherein the heating step generates heat, the method further comprising controlling the heat.

26. The method of Claim 1 further comprising supplying air at the heating station.

27. The method of Claim 1 further comprising exhausting the vapor from the collecting step.

28. An apparatus for forming a relief pattern from a photosensitive element (16) containing a composition layer having an exterior surface (17) and capable of being partially liquefied, comprising:
means for supplying an absorbent material (35) to the exterior surface (17) of the composition layer;
means for supporting the photosensitive element (16), wherein at least one of the means for supplying and the means for supporting are movable relative to the other;
means for heating (50) the exterior surface (17) of the composition layer to a temperature Tr sufficient to cause a portion of the layer to liquefy and cause one or more components in the layer to form a vapor;
means for collecting (55) the vapor at or adjacent to the heating means; and
means for contacting the photosensitive element with the absorbent material to allow at least a portion of the liquefied material of the composition layer to be absorbed by the absorbent material,
wherein the heating means (50) is at or adjacent to the contacting with the absorbent material (35).
**characterised in that**
the apparatus comprises at least one collection member (55) placed at or adjacent to where the exterior surface (17) of the photosensitive element (16) contacts the absorbent material (35).

29. The apparatus of Claim 28 further comprising means for separating the photosensitive element from the absorbent material.

30. The apparatus of Claim 28 wherein the means for supplying comprises a roller (38) mounted for rotation in a first frame portion.

31. The apparatus of Claim 28 wherein the means for supporting comprises a drum (18) mounted for rotation in a second frame portion, the drum having an outer circumferential surface (22) adapted to support the photosensitive element.

32. The apparatus of Claim 28 wherein the means for heating (50) is selected from the group consisting of
a first heating means for applying heat to the exterior surface (17) of the composition layer (16) adjacent where the absorbent material (35) contacts the layer (16), the first heating means adapted to heat the exterior surface (17) of the layer (16) to temperature T1;
a second heating means for heating the supplying means to a temperature capable of heating the exterior surface (17) of the composition layer (16) to a temperature T2 while the absorbent material (35) is contacting the exterior surface (17) of the layer (16);
a third heating means for heating the supporting means to a temperature capable of heating the exterior surface (17) of the composition layer (16) to a temperature T3;
a combination of the first heating means and the second heating means;
a combination of the first heating means and the third heating means; a combination of the second heating means and third heating means; and
a combination of the first heating means, the second heating means, and the third heating means.

33. The apparatus of Claim 28 further comprising means for confining the vapor.

34. The apparatus of Claim 28 further comprising means for managing removal of the vapor.

35. The apparatus of Claim 34 wherein the means for managing comprises means for exhausting the vapor.

36. The apparatus of Claim 35 wherein the means for exhausting the vapor is an external exhaust collection system (66, 70, 89, 62, 54).

37. The apparatus of Claim 35 wherein the means for managing further comprises means for maintaining a non-recirculating flow of the vapor.

38. The apparatus of Claim 35 wherein the means for managing further comprises means for maintaining the vapor at a temperature sufficient to keep the vapor in its vaporized state for removal.

39. The apparatus of Claim 34 wherein the means for managing further comprises means for cooling the vapor to a temperature sufficient to condense one or more of the components.

40. The apparatus of Claim 28 wherein all or a portion of the vapor cools or is cooled to form a condensate.

41. The apparatus of Claim 40 further comprising means for confining the vapor and the condensate.

42. The apparatus of Claim 40 further comprising means for managing the vapor and the condensate.

43. The apparatus of Claim 41 wherein the managing means further comprises means for separating the vapor from the condensate (70).

44. The apparatus of Claim 40 further comprising means for collecting the condensate.

45. The apparatus of Claim 40 comprising means for delivering the condensate to an absorbent material that also absorbs the liquefied material of the composition layer.

46. The apparatus of Claim 40 comprising means for delivering the condensate to a condensate absorbent material.

47. The apparatus of Claim 40 further comprising means for exposing the condensate to actinic radiation.

48. The apparatus of Claim 42 further comprising means for exhausting the vapor.

49. The apparatus of Claim 48 further comprising means for maintaining a non recirculating flow of the vapor.

50. The apparatus of Claim 48 wherein the means for exhausting the vapor comprises one or more parts composed of a condensate absorbent material.

51. The apparatus of Claim 42 wherein the means for managing further comprises means for transporting the vapor through a condensate absorbent material.

52. The apparatus of Claim 28 wherein the heating means (50) is a heating station.

53. The apparatus of Claim 28 wherein the means for collecting (55) the vapor is a manifold.

54. The apparatus of Claim 28 further comprising means for exhausting the vapor collected by the collecting means (55).

55. The apparatus of Claim 28 further comprising means for shrouding (56) the vapor at or adjacent to the heating means.

56. The apparatus of Claim 28 wherein the means for heating generates heated air, the apparatus further comprising means for removing the heated air.

57. The apparatus of Claim 28 wherein the means for heating generates heat, the apparatus further comprising controlling the heat.

58. The apparatus of Claim 28 further comprising means for supplying air at the heating station.

59. The apparatus of Claim 28 further comprising means for directing the vapor at the heating station to the means for collecting.

## Patentansprüche

1. Verfahren zur Herstellung eines Reliefmusters aus einem fotoempfindlichen Element (16), das eine Verbundschicht mit einer Außenfläche (17) aufweist und teilweise verflüssigt werden kann, das die folgenden Schritte aufweist:
Zuführen eines absorbierenden Materials (35) zur Außenfläche (17) der Verbundschicht mit einem ersten Element (38);
Halten des fotoempfindlichen Elementes mit einem zweiten Element (18);
Erhitzen der Außenfläche der Verbundschicht in einer Heizstation (50) auf eine Temperatur Tr, die ausreichend ist, um zu veranlassen, dass sich ein Teil der Schicht verflüssigt, und um zu veranlassen, dass eine oder mehrere Komponenten in der Schicht einen Dampf bilden;
Kontaktieren des fotoempfindlichen Elementes (16) mit dem absorbierenden Material (35), damit mindestens ein Teil des verflüssigten Materials der Verbundschicht durch das absorbierende Material (35) absorbiert werden kann, wobei die Heizstation (50) an der oder benachbart zur Kontaktstelle (60) mit dem absorbierenden Material (35) ist; und
Sammeln des Dampfes,
**dadurch gekennzeichnet, dass**
mindestens ein Sammelelement (55) den Dampf sammelt, während der Dampf aus der Verbundschicht am fotoempfindlichen Element (16) austritt, wobei das mindestens eine Sammelelement an oder benachbart der Stelle angeordnet ist, wo die Außenfläche (17) am fotoempfindlichen Element (16) das absorbierende Material (35) kontaktiert.

2. Verfahren nach Anspruch 1, bei dem der Schritt des Erhitzens ausgewählt wird aus der Gruppe, die besteht aus:
einem ersten Erhitzen, bei dem Wärme an der Außenfläche (17) der Verbundschicht (16) angewandt wird, benachbart der Stelle, wo das absorbierende Material (35) die Schicht (16) kontaktiert, wobei das erste Erhitzen so ausgeführt wird, dass die Außenfläche (17) der Schicht (16) auf die Temperatur T1 erhitzt wird;
einem zweiten Erhitzen, um das erste Element (38) auf eine Temperatur zu erhitzen, die die Außenfläche (17) der Verbundschicht (16) auf eine Temperatur T2 erhitzen kann, während das absorbierende Material (35) die Außenfläche der Schicht (16) kontaktiert;
einem dritten Erhitzen, um das zweite Element (18) auf eine Temperatur zu erhitzen, die die Außenfläche (17) der Verbundschicht (16) auf eine Temperatur T3 erhitzen kann;
einer Kombination von erstem Erhitzen und zweitem Erhitzen;
einer Kombination von erstem Erhitzen und drittem Erhitzen:
einer Kombination von zweitem Erhitzen und drittem Erhitzen; und
einer Kombination von erstem Erhitzen, zweitem Erhitzen und drittem Erhitzen.

3. Verfahren nach Anspruch 1, bei dem der Schritt des Kontaktierens durch Pressen des fotoempfindlichen Elementes (16) und des absorbierenden Materials (35) in Kontakt bei einem Druck durchgeführt wird, der ausreichend ist, damit mindestens ein Teil des verflüssigten Materials der Verbundschicht durch das absorbierende Material absorbiert wird.

4. Verfahren nach Anspruch 1, das außerdem den Schritt des Trennens des fotoempfindlichen Elementes (16) vom absorbierenden Material (35) aufweist.

5. Verfahren nach Anspruch 1, das außerdem den Schritt des Einschließens des Dampfes aufweist.

6. Verfahren nach Anspruch 5, bei dem sich der gesamte oder ein Teil des Dampfes während oder nach dem Schritt des Einschließens abkühlt oder abgekühlt wird, um ein Kondensat zu bilden.

7. Verfahren nach Anspruch 6, bei dem der Schritt des Einschließens außerdem das Einschließen des Kondensates aufweist.

8. Verfahren nach Anspruch 6, bei dem sich der Dampf abkühlt, um ein Kondensat zu bilden.

9. Verfahren nach Anspruch 6, das außerdem den Schritt des Sammelns des Kondensates aufweist.

10. Verfahren nach Anspruch 5, das außerdem den Schritt des Handhabens des Entfernens des Dampfes während oder nach dem Schritt des Einschließens aufweist.

11. Verfahren nach Anspruch 10, bei dem sich der gesamte oder ein Teil des Dampfes abkühlt oder abgekühlt wird, um ein Kondensat zu bilden, und bei dem der Schritt des Handhabens das Entfernen des Kondensates aufweist.

12. Verfahren nach Anspruch 11, bei dem der Schritt des Handhabens außerdem das Trennen des Dampfes vom Kondensat und das Sammeln des Kondensates aufweist.

13. Verfahren nach Anspruch 11, bei dem der Schritt des Handhabens außerdem das Zuführen des Kondensates zu einem absorbierenden Material (35) aufweist, das ebenfalls das verflüssigte Material der Verbundschicht absorbiert.

14. Verfahren nach Anspruch 11, bei dem der Schritt des Handhabens das Zuführen des Kondensates zu einem kondensatabsorbierenden Material (35) aufweist.

15. Verfahren nach Anspruch 11, bei dem der Schritt des Handhabens außerdem das Aussetzen des Kondensates einer aktinischen Strahlung aufweist.

16. Verfahren nach Anspruch 10, bei dem der Schritt des Handhabens das Ausstoßen des eingeschlossenen Dampfes zu einem externen Ausstoßsammelsystem (66, 70, 89, 62, 54) aufweist.

17. Verfahren nach Anspruch 16, das außerdem den Schritt des Aufrechterhaltens eines nichtzurückführenden Stromes des eingeschlossenen Dampfes im Ausstoßsammelsystem aufweist.

18. Verfahren nach Anspruch 16, bei dem das externe Ausstoßsammelsystem ein oder mehr Teile aufweist, die aus einem kondensatabsorbierenden Material bestehen.

19. Verfahren nach Anspruch 10, das außerdem den Schritt des Transportierens des eingeschlossenen Dampfes durch ein kondensatabsorbierendes Material aufweist.

20. Verfahren nach Anspruch 10, bei dem der Schritt des Handhabens das Halten des Dampfes auf einer Temperatur aufweist, die ausreichend ist, um den Dampf in seinem Verdampfungszustand für das Entfernen zu halten.

21. Verfahren nach Anspruch 10, bei dem der Schritt des Handhabens das Abkühlen des Dampfes auf eine Temperatur aufweist, die ausreichend ist, um eine oder mehrere der Komponenten zu kondensieren.

22. Verfahren nach Anspruch 1, das außerdem das Einhüllen des Dampfes an der Heizstation (50) aufweist.

23. Verfahren nach Anspruch 1, bei dem das fotoempfindliche Element (16) aus der Gruppe ausgewählt wird, die besteht aus: einer Folie; einem Zylinder; und einer Folie auf einer Hülse.

24. Verfahren nach Anspruch 1, bei dem der Schritt des Erhitzens erhitzte Luft erzeugt, wobei das Verfahren außerdem das Entfernen der erhitzten Luft aufweist.

25. Verfahren nach Anspruch 1, bei dem der Schritt des Erhitzens Wärme erzeugt, wobei das Verfahren außerdem das Steuern der Wärme aufweist.

26. Verfahren nach Anspruch 1, das außerdem das Zuführen von Luft an der Heizstation aufweist.

27. Verfahren nach Anspruch 1, das außerdem das Ausstoßen des Dampfes aus dem Sammelschritt aufweist.

28. Vorrichtung zur Herstellung eines Reliefmusters aus einem fotoempfindlichen Element (16), das eine Verbundschicht mit einer Außenfläche (17) aufweist und teilweise verflüssigt werden kann, die aufweist:
eine Einrichtung für das Zuführen eines absorbierenden Materials (35) zur Außenfläche (17) der Verbundschicht;
eine Einrichtung für das Halten des fotoempfindlichen Elementes (16), wobei mindestens eine der Einrichtung für das Zuführen und der Einrichtung für das Halten relativ zueinander beweglich sind;
eine Einrichtung für das Erhitzen (50) der Außenfläche (17) der Verbundschicht auf eine Temperatur Tr, die ausreichend ist, um zu veranlassen, dass sich ein Teil der Schicht verflüssigt, und um zu veranlassen, dass eine oder mehrere Komponenten in der Schicht einen Dampf bilden;
eine Einrichtung für das Sammeln (55) des Dampfes an der oder benachbart zur Heizeinrichtung; und
eine Einrichtung für das Kontaktieren des fotoempfindlichen Elementes mit dem absorbierenden Material, damit mindestens ein Teil des verflüssigten Materials der Verbundschicht durch das absorbierende Material absorbiert werden kann,
wobei die Heizeinrichtung (50) an der oder benachbart zur Kontaktstelle mit dem absorbierenden Material (35) ist;
**dadurch gekennzeichnet, dass**
die Vorrichtung mindestens ein Sammelelement (55) aufweist, das an der oder benachbart der Stelle angeordnet ist, wo die Außenfläche (17) des fotoempfindlichen Elementes (16) das absorbierende Material (35) kontaktiert.

29. Vorrichtung nach Anspruch 28, die außerdem eine Einrichtung für das Trennen des fotoempfindlichen Elementes vom absorbierenden Material aufweist.

30. Vorrichtung nach Anspruch 28, bei der die Einrichtung für das Zuführen eine Rolle (38) aufweist, die für eine Drehung in einem ersten Rahmenabschnitt montiert ist.

31. Vorrichtung nach Anspruch 28, bei der die Einrichtung für das Halten eine Trommel (18) aufweist, die für eine Drehung in einem zweiten Rahmenabschnitt montiert ist, wobei die Trommel eine äußere Umfangsfläche (22) aufweist, die ausgebildet ist, um das fotoempfindliche Element zu halten.

32. Vorrichtung nach Anspruch 28, bei der die Einrichtung für das Erhitzen (50) ausgewählt wird aus der Gruppe, die besteht aus:
einer ersten Heizeinrichtung für das Anwenden von Wärme an der Außenfläche (17) der Verbundschicht (16), benachbart der Stelle, wo das absorbierende Material (35) die Schicht (16) kontaktiert, wobei die erste Heizeinrichtung so ausgeführt ist, dass die Außenfläche (17) der Schicht (16) auf die Temperatur T1 erhitzt wird;
einer zweiten Heizeinrichtung für das Erhitzen der Einrichtung für das Zuführen auf eine Temperatur, die die Außenfläche (17) der Verbundschicht (16) auf eine Temperatur T2 erhitzen kann, während das absorbierende Material (35) die Außenfläche (17) der Schicht (16) kontaktiert;
einer dritten Heizeinrichtung für das Erhitzen der Einrichtung für das Halten auf eine Temperatur, die die Außenfläche (17) der Verbundschicht (16) auf eine Temperatur T3 erhitzen kann;
einer Kombination der ersten Heizeinrichtung und der zweiten Heizeinrichtung;
einer Kombination der ersten Heizeinrichtung und der dritten Heizeinrichtung:
einer Kombination der zweiten Heizeinrichtung und der dritten Heizeinrichtung; und
einer Kombination der ersten Heizeinrichtung, der zweiten Heizeinrichtung und der dritten Heizeinrichtung.

33. Vorrichtung nach Anspruch 28, die außerdem eine Einrichtung für das Einschließen des Dampfes aufweist.

34. Vorrichtung nach Anspruch 28, die außerdem eine Einrichtung für das Handhaben des Entfernens des Dampfes aufweist.

35. Vorrichtung nach Anspruch 34, bei der die Einrichtung für das Handhaben eine Einrichtung für das Ausstoßen des Dampfes aufweist.

36. Vorrichtung nach Anspruch 35, bei der die Einrichtung für das Ausstoßen des Dampfes ein externes Ausstoßsammelsystem (66, 70, 89, 62, 54) ist.

37. Vorrichtung nach Anspruch 35, bei der die Einrichtung für das Handhaben außerdem eine Einrichtung für das Aufrechterhalten eines nichtzurückführenden Dampfstromes aufweist.

38. Vorrichtung nach Anspruch 35, bei der die Einrichtung für das Handhaben außerdem eine Einrichtung für das Halten des Dampfes auf einer Temperatur aufweist, die ausreichend ist, um den Dampf in seinem Verdampfungszustand für ein Entfernen zu halten.

39. Vorrichtung nach Anspruch 34, bei der die Einrichtung für das Handhaben außerdem eine Einrichtung für das Abkühlen des Dampfes auf eine Temperatur aufweist, die ausreichend ist, um eine oder mehrere der Komponenten zu kondensieren.

40. Vorrichtung nach Anspruch 28, bei der sich der gesamte oder ein Teil des Dampfes abkühlt oder abgekühlt wird, um ein Kondensat zu bilden.

41. Vorrichtung nach Anspruch 40, die außerdem eine Einrichtung für das Einschließen des Dampfes und des Kondensates aufweist.

42. Vorrichtung nach Anspruch 40, die außerdem eine Einrichtung für das Handhaben des Dampfes und des Kondensates aufweist.

43. Vorrichtung nach Anspruch 41, bei der die Handhabungseinrichtung außerdem eine Einrichtung für das Trennen des Dampfes vom Kondensat (70) aufweist.

44. Vorrichtung nach Anspruch 40, die außerdem eine Einrichtung für das Sammeln des Kondensates aufweist.

45. Vorrichtung nach Anspruch 40, die die Einrichtung für das Zuführen des Kondensates zu einem absorbierenden Material aufweist, das ebenfalls das verflüssigte Material der Verbundschicht absorbiert.

46. Vorrichtung nach Anspruch 40, die eine Einrichtung für das Zuführen des Kondensates zu einem kondensatabsorbierenden Material aufweist.

47. Vorrichtung nach Anspruch 40, die außerdem eine Einrichtung für das Aussetzen des Kondensates einer aktinischen Strahlung aufweist.

48. Vorrichtung nach Anspruch 42, die außerdem eine Einrichtung für das Ausstoßen des Dampfes aufweist.

49. Vorrichtung nach Anspruch 48, die außerdem eine Einrichtung für das Aufrechterhalten eines nichtzurückkehrenden Dampfstromes aufweist.

50. Vorrichtung nach Anspruch 48, bei der die Einrichtung für das Ausstoßen des Dampfes ein oder mehrere Teile aufweist, die aus kondensatabsorbierendem Material bestehen.

51. Vorrichtung nach Anspruch 42, bei der die Einrichtung für das Handhaben außerdem eine Einrichtung für das Transportieren des Dampfes durch ein kondensatabsorbierendes Material aufweist.

52. Vorrichtung nach Anspruch 28, bei der die Heizeinrichtung (50) eine Heizstation ist.

53. Vorrichtung nach Anspruch 28, bei der die Einrichtung für das Sammeln (55) des Dampfes eine Sammelleitung ist.

54. Vorrichtung nach Anspruch 28, die außerdem eine Einrichtung für das Ausstoßen des Dampfes aufweist, der von der Sammeleinrichtung (55) gesammelt wird.

55. Vorrichtung nach Anspruch 28, die außerdem eine Einrichtung für das Einhüllen (56) des Dampfes an oder benachbart der Heizeinrichtung aufweist.

56. Vorrichtung nach Anspruch 28, bei der die Einrichtung für das Erhitzen erhitzte Luft erzeugt, wobei die Vorrichtung außerdem eine Einrichtung für das Entfernen der erhitzten Luft aufweist.

57. Vorrichtung nach Anspruch 28, bei der die Einrichtung für das Erhitzen Wärme erzeugt, wobei die Vorrichtung außerdem das Steuern der Wärme aufweist.

58. Vorrichtung nach Anspruch 28, die außerdem eine Einrichtung für das Zuführen von Luft an der Heizstation aufweist.

59. Vorrichtung nach Anspruch 28, die außerdem eine Einrichtung für das Lenken des Dampfes an der Heizstation zur Einrichtung für das Sammeln aufweist.

## Revendications

1. Procédé de formation d'un motif en relief à partir d'un élément photosensible (16), contenant ne couche de composition comportant une surface externe (17) et se prêtant à une liquéfaction partielle, comprenant les étapes ci-dessous :
amenée d'un matériau absorbant (35) vers la surface externe (17) de la couche de composition par un premier élément (38) ;
support de l'élément photosensible par un deuxième élément (18) ;
chauffage de la surface externe de la couche de composition au niveau d'une station de chauffage (50) à une température Tr, suffisante pour entraîner la liquéfaction d'une partie de la couche et pour entraîner un ou plusieurs composants de la couche à former une vapeur ;
mise en contact de l'élément photosensible (16) avec un matériau absorbant (35) pour permettre l'absorption d'au moins une partie du matériau liquéfié de la couche de composition par le matériau absorbant (35), la station de chauffage (50) étant agencée au niveau du point de contact (60) avec le matériau absorbant (35) ou en un emplacement adjacent à celui-ci ; et
collecte de la vapeur ;
**caractérisé en ce que**
au moins un élément de collecte (55) collecte la vapeur lors de l'émission de la vapeur de la couche de composition au niveau de l'élément photosensible (16), le au moins un élément de collecte étant agencé au niveau du point de contact entre la surface externe (17) de l'élément photosensible (16) et le matériau absorbant (35), ou en un emplacement adjacent à celui-ci.

2. Procédé selon la revendication 1, dans lequel l'étape de chauffage est sélectionnée du groupe constitué de :
un premier chauffage, appliquant de la chaleur à la surface externe (17) de la couche de composition (16), agencé en un point adjacent au point de contact entre le matériau absorbant (35) et la couche (16), le premier chauffage étant adapté pour chauffer la surface externe (17) de la couche (16) à une température T1 ;
un deuxième chauffage, pour chauffer le premier élément (38) à une température capable de chauffer la surface externe (17) de la couche de composition (16) à une température T2, au cours de la mise en contact du matériau absorbant (35) avec la surface externe de la couche (16) ;
un troisième chauffage, pour chauffer le deuxième élément (18) à une température capable de chauffer la surface externe (17) de la couche de composition (16) à une température T3 ;
une combinaison du premier chauffage et du deuxième chauffage ;
une combinaison du premier chauffage et du troisième chauffage ;
une combinaison du deuxième chauffage et du troisième chauffage ; et
une combinaison du premier chauffage, du deuxième chauffage et du troisième chauffage.

3. Procédé selon la revendication 1, dans lequel l'étape de mise en contact est exécutée en mettant en contact par pression l'élément photosensible (16) et le matériau absorbant (35), à une pression suffisante pour permettre l'absorption d'au moins une partie du matériau liquéfié de la couche de composition par le matériau absorbant.

4. Procédé selon la revendication 1, comprenant en outre l'étape de séparation de l'élément photosensible (16) du matériau absorbant (35).

5. Procédé selon la revendication 1, comprenant en outre l'étape de confinement de la vapeur.

6. Procédé selon la revendication 5, dans lequel l'ensemble ou une partie de la vapeur se refroidit ou est refroidie pour former un condensat pendant ou après l'étape de confinement.

7. Procédé selon la revendication 6, dans lequel l'étape de confinement comprend en outre le confinement du condensat.

8. Procédé selon la revendication 6, dans lequel la vapeur se refroidit pour former un condensat.

9. Procédé selon la revendication 6, comprenant en outre l'étape de collecte du condensat.

10. Procédé selon la revendication 5, comprenant en outre l'étape de gestion de l'élimination de la vapeur au pendant ou après l'étape de confinement.

11. Procédé selon la revendication 10, dans lequel l'ensemble ou une partie de la vapeur se refroidit ou est refroidie pour former un condensat, l'étape de gestion comprenant l'élimination du condensat.

12. Procédé selon la revendication 11, dans lequel l'étape de gestion comprend en outre la séparation de la vapeur du condensat et la collecte du condensat.

13. Procédé selon la revendication 11, dans lequel l'étape de gestion comprend en outre le transfert du condensat vers un matériau absorbant (35), absorbant également le matériau liquéfié de la couche de composition.

14. Procédé selon la revendication 11, dans lequel l'étape de gestion comprend le transfert du condensat vers un matériau d'absorption du condensat (35).

15. Procédé selon la revendication 11, dans lequel l'étape de gestion comprend en outre l'exposition du condensat à un rayonnement actinique.

16. Procédé selon la revendication 10, dans lequel l'étape de gestion comprend l'évacuation de la vapeur confinée vers un système de collecte d'évacuation externe (66, 70, 89, 62, 54).

17. Procédé selon la revendication 16, comprenant en outre l'étape de maintien d'un écoulement sans recirculation de la vapeur confinée dans le système de collecte d'évacuation.

18. Procédé selon la revendication 16, dans lequel le système de collecte d'évacuation comprend une ou plusieurs parties composées d'un matériau d'absorption du condensat.

19. Procédé selon la revendication 10, comprenant en outre l'étape de transport de la vapeur confinée à travers un matériau d'absorption du condensat.

20. Procédé selon la revendication 10, dans lequel l'étape de gestion comprend le maintien de la vapeur à une température suffisante pour maintenir la vapeur dans son état vaporisé en vue de son élimination.

21. Procédé selon la revendication 10, dans lequel l'étape de gestion comprend le refroidissement de la vapeur à une température suffisante pur condenser un ou plusieurs des composants.

22. Procédé selon la revendication 1, comprenant en outre l'étape d'enveloppement de la vapeur au niveau de la station de chauffage (50).

23. Procédé selon la revendication 1, dans lequel l'élément photosensible (16) est sélectionné dans le groupe constitué d'une feuille, d'un cylindre et d'une feuille sur un manchon.

24. Procédé selon la revendication 1, dans lequel l'étape de chauffage produit de l'air chauffé, le procédé comprenant en outre l'étape d'élimination de l'air chauffé.

25. Procédé selon la revendication 1, dans lequel l'étape de chauffage produit de la chaleur, le procédé comprenant en outre l'étape de contrôle de la chaleur.

26. Procédé selon la revendication 1, comprenant en outre l'étape d'amenée d'air au niveau de la station de chauffage.

27. Procédé selon la revendication 1, comprenant en outre l'étape d'évacuation de la vapeur provenant de l'étape de collecte.

28. Appareil pour former un motif en relief à partir d'un élément photosensible (16), contenant une couche de composition comportant une surface externe (17) et se prêtant à une liquéfaction partielle, comprenant :
un moyen pour amener un matériau absorbant (35) vers la surface externe (17) de la couche de composition ;
un moyen pour supporter l'élément photosensible (16), au moins un moyen, le moyen d'amenée ou le moyen de support, pouvant se déplacer par apport à l'autre moyen ;
un moyen pour chauffer (50) la surface externe (17) de la couche de composition à une température Tr suffisante pour entraîner la liquéfaction d'une partie de la couche et pour entraîner un ou plusieurs composants de la couche à former une vapeur ;
un moyen pour collecter (55) la vapeur au niveau du moyen de chauffage ou en un emplacement adjacent à celui-ci ; et
un moyen pour mettre en contact l'élément photosensible avec le matériau absorbant pour permettre l'absorption d'au moins une partie du matériau liquéfié de la couche de composition par le matériau absorbant ;
le moyen de chauffage (50) étant agencé au niveau du point de contact avec le matériau absorbant (35) ou en un emplacement adjacent à celui-ci ;
**caractérisé en ce que**
l'appareil comprend au moins un élément de collecte (55) placé au niveau du point de contact entre la surface externe (17) de l'élément photosensible (16) et le matériau absorbant (35) ou en un emplacement adjacent à celui-ci.

29. Appareil selon la revendication 28, comprenant en outre un moyen pour séparer l'élément photosensible du matériau absorbant.

30. Appareil selon la revendication 28, dans lequel le moyen d'amenée comprend un rouleau (38) monté en vue d'une rotation dans une première partie de cadre.

31. Appareil selon la revendication 28, dans lequel le moyen de support comprend un tambour (18), monté en vue d'une rotation dans une deuxième partie de cadre, le tambour comportant une surface circonférentielle externe (22) adaptée pour supporter l'élément photosensible.

32. Appareil selon la revendication 28, dans lequel le moyen de chauffage (50) est sélectionné dans le groupe constitué de :
un premier moyen de chauffage, pour appliquer de la chaleur à la surface externe (17) de la couche de composition (16), en un emplacement adjacent au point de contact entre le matériau absorbant (35) et la couche (16), le premier moyen de chauffage étant adapté pour chauffer la surface externe (17) de la couche (16) à une température T1
un deuxième moyen de chauffage, pour chauffer le moyen d'amenée à une température capable de chauffer la surface externe (17) de la couche de composition (16) à une température T2, au cours de la mise en contact du matériau absorbant (35) avec la surface externe (17) de la couche (16) ;
un troisième moyen de chauffage, pour chauffer le moyen de support à une température capable de chauffer la surface externe (17) de la couche de composition (16) à une température T3 ;
une combinaison du premier moyen de chauffage et du deuxième moyen de chauffage ;
une combinaison du premier moyen de chauffage et du troisième moyen de chauffage ;
une combinaison du deuxième moyen de chauffage et du troisième moyen de chauffage ; et
une combinaison du premier moyen de chauffage, du deuxième moyen de chauffage et du troisième moyen de chauffage.

33. Appareil selon la revendication 28, comprenant en outre un moyen pour confiner la vapeur.

34. Appareil selon la revendication 28, comprenant en outre un moyen pour gérer l'élimination de la vapeur.

35. Appareil selon la revendication 34, dans lequel le moyen de gestion comprend un moyen pour évacuer la vapeur.

36. Appareil selon la revendication 35, dans lequel le moyen d'évacuation de la vapeur est un système de collecte d'évacuation externe (66, 70, 89, 62, 54).

37. Appareil selon la revendication 35, dans lequel le moyen de gestion comprend en outre un moyen pour maintenir un écoulement sans recirculation de la vapeur.

38. Appareil selon la revendication 35, dans lequel le moyen de gestion comprend en outre un moyen pour maintenir la vapeur à une température suffisante pour maintenir la vapeur dans son état vaporisé en vue de son élimination.

39. Appareil selon la revendication 34, dans lequel le moyen de gestion comprend en outre un moyen pour refroidir la vapeur à une température suffisante pour condenser un ou plusieurs des composants.

40. Appareil selon la revendication 28, dans lequel l'ensemble ou une partie de la vapeur refroidit ou est refroidie pour former un condensat.

41. Appareil selon la revendication 40, comprenant en outre un moyen pour confiner la vapeur et le condensat.

42. Appareil selon la revendication 40, comprenant en outre un moyen pour assurer la gestion de la vapeur et du condensat.

43. Appareil selon la revendication 41, dans lequel le moyen de gestion comprend en outre un moyen pour séparer la vapeur du condensat (70).

44. Appareil selon la revendication 40, comprenant en outre un moyen pour collecter le condensat.

45. Appareil selon la revendication 40, comprenant un moyen pour transférer le condensat vers un matériau absorbant, absorbant également le matériau liquéfié de la couche de composition.

46. Appareil selon la revendication 40, comprenant un moyen pour transférer le condensat vers un matériau d'absorption du condensat.

47. Appareil selon la revendication 40, comprenant en outre un moyen pour exposer le condensat à un rayonnement actinique.

48. Appareil selon la revendication 42, comprenant en outre un moyen pour évacuer la vapeur.

49. Appareil selon la revendication 48, comprenant en outre un moyen pour maintenir un écoulement sans recirculation de la vapeur.

50. Appareil selon la revendication 48, dans lequel le moyen d'évacuation de la vapeur comprend une ou plusieurs parties composées d'un matériau d'absorption du condensat.

51. Appareil selon la revendication 42, dans lequel le moyen de gestion comprend un moyen pour transporter la vapeur à travers un matériau d'absorption du condensat.

52. Appareil selon la revendication 28, dans lequel le moyen de chauffage (50) est une station de chauffage.

53. Appareil selon la revendication 28, dans lequel le moyen de collecte (55) de la vapeur est un collecteur.

54. Appareil selon la revendication 28, comprenant en outre un moyen pour évacuer la vapeur collectée par le moyen de collecte (55).

55. Appareil selon al revendication 28, comprenant en outre un moyen pour envelopper (56) la vapeur au niveau du moyen de chauffage ou en un emplacement adjacent à celui-ci.

56. Appareil selon la revendication 28, dans lequel le moyen de chauffage produit de l'air chauffé, l'appareil comprenant en outre un moyen pour éliminer l'air chauffé.

57. Appareil selon la revendication 28, dans lequel le moyen de chauffage produit de la chaleur, l'appareil comprenant en outre un moyen de contrôle de la chaleur.

58. Appareil selon la revendication 28, comprenant en outre un moyen pour amener de l'air au niveau de la station de chauffage.

59. Appareil selon la revendication 28, comprenant en outre un moyen pour diriger la vapeur au niveau de la station de chauffage vers le moyen de collecte.
